(19) Europäisches Patentamt
European Patent Office
Office européen des brevets

(11) Publication number: **0 160 365**
**B1**

(12) # EUROPEAN PATENT SPECIFICATION

(45) Date of publication of patent specification: **17.05.89**

(51) Int. Cl.$^4$: **H 01 L 45/00**, H 01 L 21/205, C 23 C 14/14, C 23 C 14/38 // H05H1/46

(21) Application number: **85301575.8**

(22) Date of filing: **07.03.85**

(54) **Method of making amorphous semiconductor alloys and devices using microwave energy.**

(30) Priority: **30.04.84 US 605575**

(43) Date of publication of application:
**06.11.85 Bulletin 85/45**

(45) Publication of the grant of the patent:
**17.05.89 Bulletin 89/20**

(84) Designated Contracting States:
**BE CH DE FR GB IT LI LU NL SE**

(56) References cited:
**EP-A-0 104 907**
**GB-A-2 033 355**
**US-A-4 363 828**

**The file contains technical information submitted after the application was filed and not included in this specification**

(73) Proprietor: **ENERGY CONVERSION DEVICES, INC.**
**1675 West Maple Road**
**Troy Michigan 48084 (US)**

(72) Inventor: **Ovshinshy, Stanford R.**
**2700 Squirrel Road**
**Bloomfield Hills Michigan 48013 (US)**
Inventor: **Walter, Lee**
**454 North Fox Hills Drive Apt. 3**
**Bloomfield Hills Michigan 48013 (US)**
Inventor: **Allred, David D.**
**3980 N. Adams**
**Troy Michigan 48084 (US)**
Inventor: **Hudgens, Stephen J.**
**2 Alexandria Town**
**Southfield Michigan 48075 (US)**

(74) Representative: **Jackson, Peter Arthur et al**
**GILL JENNINGS & EVERY 53-64 Chancery Lane**
**London WC2A 1HN (GB)**

**EP 0 160 365 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Amorphous semiconductor alloys are known to be capable of producing high quality, low cost photoresponsive devices. High quality semiconductor alloys include a semiconductor, such as silicon or germanium, and one or more compensating agents to satisfy the dangling bonds in the amorphous material and reduce the density of localized states. Reduction of the density of localized states is essential to produce electronic quality material. It has been found that fluorine or fluorine and hydrogen together can act as compensating agents in semiconductor alloys deposited in a glow discharge process. These results are disclosed in U.S. Patent Nos. 4,217,374 to Stanford R. Ovshinsky and Masatsugu Izu and 4,226,898 to Stanford R. Ovshinsky and Arun Madan.

The glow discharge deposition process suffers from relatively slow deposition rates and low utilization of the reaction gas feed stock, important considerations in commercial manufacture of photovoltaic and, particularly, xerographic devices. When high radio frequency power densities are used in glow discharge process to enhance deposition rates, films with poor electrical properties and increased densities of defect states result. In addition, gas phase nucleation occurs undesirably producing a powder in the reaction vessel. It is known in a glow discharge deposition process that the optimum deposition power and pressure occur at the minimum of the so-called Paschen curve. The Paschen curve defines the voltage (V) needed to sustain a glow discharge plasma as a function of pressure (P) for electrodes separated by a distance (D). In a typically sized, conventional radio frequency glow discharge system, the minimum in the Paschen curve occurs between approximately 10 to 100 pascal.

Attempts have also been made to increase the gas utilization efficiency in radio frequency glow discharge plasmas by high power deposition of a dilute mixture of silane ($SiH_4$) in an inert carrier gas such as argon. However undesirable film growth producing columnar morphology results. Knights, 35/36 *Journal of Non-crystalline Solids*, p. 159 (1980).

One group reported glow discharge amorphous silicon alloy deposition using microwave energy at 2.45 GHz at pressures typical of conventional radio frequency or direct current glow discharge processes. C. Mailhiot et al. 35/36. *Journal of Non-Crystalline Solids*, p. 207—212 (1980) describe films deposited at pressures of 39 to 45 pascal and deposition rates of 2.3 to 3.4 nanometers per second. The deposited films, which were of poor electrical quality showed clear indications of nonhomogeneous structure.

The inventors have solved the problem of increasing the deposition rate in a glow discharge by raising the excitation frequency, but at a lowered pressure. The inventors have learned and applied, contrary to Mailhiot et al., that for a given deposition system the minimum in the Paschen curve shifts to lower pressure values as the frequency of glow discharge excitation increases. The shift in the minimum of the Paschen curve is believed to occur because, for a given gas pressure, the higher excitation frequency produces rapid reversals of the applied electric field. The rapidly changing field causes electrons in the plasma to collide with more feedstock molecules than with lower frequency fields. As a result, a substantially increased deposition rate of 10 nanometers per second or more and a feedstock conversion efficiency approaching 100 percent are achieved in the production of electronic quality amorphous semiconductor films. A conventional radio frequency glow discharge deposition process, for example, 13.56 MHz, at 27 to 66 pascals, produces high quality films at deposition rates of approximately 1 nanometer per second and feedstock utilization of approximately 10 percent. Mailhiot et al. reported depositions (2.45 GHz, 39 to 45 Pa) that produced poor quality films at 2 to 3 nanometer per second deposition rates.

Photovoltaic devices may be encapsulated by depositing a relatively thin layer of transparent insulating materials using the same process. For example, silicon nitride ($Si_3N_4$) or silicon dioxide ($SiO_2$) may be formed, for example, by a microwave glow discharge in silane and ammonia or nitrogen, and in silane and oxygen, respectively.

According to the present invention, therefore, a process for depositing an amorphous semiconductor alloy film onto a substrate from a flow discharge excited by microwave energy, the process comprising coupling microwave energy having a frequency of 2.45 GHz into a substantially enclosed reaction vessel containing a substrate, and introducing into the vessel reaction gas to establish a glow discharge plasma within the vessel containing reaction gas species derived from the reaction gas, (as disclosed in EP—A—0104907) is characterised in that the reaction vessel is maintained at a pressure corresponding substantially to that represented by the minimum on the Paschen curve.

In the accompanying drawings:—

Figure 1 is a perspective view, partly broken away, of a microwave plasma deposition system for depositing amorphous semiconductor alloy films in accordance with the invention.

Figure 2 is a fragmentary sectional view of an embodiment of a Schottky barrier solar cell illustrating one application of the amorphous semiconductor photoreceptive alloys made by the process of the invention.

Figure 3 is a fragmentary sectional view of p-n junction solar cell device including a doped amorphous semiconductor alloy made by the process of the invention.

Figure 4 is a fragmentary sectional view of a photodetection device that includes an amorphous semiconductor alloy made by the process of the invention.

Figure 5 is a fragmentary sectional view of a xerographic drum including an amorphous semiconductor alloy made by the process of the invention.

Figure 6 is a fragmentary sectional view of p-i-n junction solar cell device.

Figure 7 is a fragmentary sectional view of an n-i-p junction solar cell device.

Figure 8 is a partial plan view of an alternative gas feed arrangement for the apparatus of Fig. 1 in accordance with a further embodiment of the present invention.

Figure 9 is a partial plan view of a free radical distribution system for the apparatus of Figure 1 in accordance with another embodiment of the present invention.

Figure 10 is a partial perspective view of another microwave plasma deposition system in accordance with a still further embodiment of the present invention.

Figure 11 is a modified Paschen curve for conventional radio frequency deposition conditions.

Figure 12 is a modified Paschen curve for the microwave deposition conditions of the present invention.

In Figure 1, a microwave deposition apparatus 10 suitable for practicing the invention is shown. Apparatus 10 comprises a transparent tubular chamber or vessel 12 containing a substrate 14 upon which amorphous semiconductor alloy films are to be deposited. The substrate is heated by a radiant heater 16 and the exterior of the chamber is irradiated by a microwave energy source 17. Reaction gases passing from inlets 46 to an outlet 20 at opposite ends of the chamber 12 absorb microwave energy from the source 17 in the area of the substrate. The combination of the reaction gases and the microwave energy from source 17 causes the formation of a plasma in the area of the substrate, resulting in the deposition of a film 22. The reaction gases include at least one semiconductor-containing compound. The temperature of the substrate can be between room temperature and about 400°C and preferably 250°C to 325°C, and the frequency of the microwave energy is 2.45 GHz.

Chamber 12 comprises a central quartz portion 24 and opposing end portions 26. End portions 26 are closed by a pair of end fittings 30 and 32. Each of the end fittings include a sleeve portion 34 extending from a closed end 36 to an open end portion. The open end portion is threaded to receive a collar 40 having an inwardly extending annular flange 42 at one of its ends. An o-ring (not shown) is confined in a space between flange 42 and the end portion for compression against quartz portion 26 to form an airtight seal.

End fittings 30 and 32 are preferably made of stainless steel or other suitable noncorrosive metal, with closed ends 36 being welded or otherwise permanently joined to sleeve portions 34. Closed end 36 of end fitting 32 is provided with gas inlets 46 through which the deposition gases are introduced into vessel 12. An inert gas such as argon can be introduced through one of inlets 46 to assist in sustaining the plasma.

Gas inlets 46 are preferably connected to a conventional gas manifold (not shown) for establishing regulated flows of reaction gases therein. Outlet 20 connects to selectable first and second pumps. The first pump provides for initial evacuation of the chamber. The second pump provides withdrawal of unused reaction gases during operation and maintenance of the proper deposition pressure.

Microwave energy source 17 preferably comprises a microwave energy generator 18 coupled to an antenna 19. Antenna 19 is disposed within a reflective housing 21 for concentration of the microwave energy transmitted into chamber 12. The antenna as illustrated is a vertical antenna, preferably one-quarter wavelength long. The tip of the antenna just touches the outer surface of vessel 12 to maximize transmission of its output to the reaction gases.

Radiant heater 16 preferably comprises a conventional resistive heater. Heat is transmitted to substrate 14 and chamber 12 by radiation, without significant direct heating of the reaction gases. Alternatively, a resistive heating arrangement (not shown) may be provided within chamber 12 for heating substrate 14. In that case, power lines for the heating element would be passed through one of the end fittings.

In operation, system 10 is first pumped down to below a desired deposition pressure, such as .001 pascal. The reaction gas mixture or gases such as silicon tetrafluoride ($SiF_4$), silane ($SiH_4$), silicon tetrafluoride and silane, silane and germane ($GeH_4$), or silicon tetrafluoride and germane are fed into inlet chamber 24 through separate inlet conduits 46 and chamber 12 is brought up to the desired operating pressure. Other reaction gases that can be used are germane, germanium tetrafluoride ($GeF_4$), germanium tetrafluoride and silicon tetrafluoride. Hydrogen ($H_2$) can be added to all these gases and mixtures.

The output power of microwave energy generator 18 is adjusted to between about 20 and 115 watts depending on the volume of the gas contained in the plasma and the composition of the gas. These power outputs preferably correlate to a power density of about .1 to 1.2 watts per cubic centimeter. The flow rate of the reaction gases can be between 1 to 50 SCCM. The vessel is evacuated to an operating pressure of .13 to 13 pascal and preferably about .7 pascal or less. With the foregoing system parameters, deposition rates of 5 to 25 nanometers per second or higher, as controlled by the gas flow rate, can be obtained. The reaction gas is converted to deposition species at a conversion efficiency of essentially 100 percent. Even at these high deposition rates, the deposited amorphous semiconductor films do not have any significant powder or polymeric inclusions and exhibit high-quality photoresponsive characteristics suitable for photovoltaic and other applications.

For making photovoltaic or other doped devices by the process of the invention, dopants can be introduced into vessel 12 for making the deposited film either p-type or n-type. For example, to make a p-type film, diborane gas ($B_2H_6$) can be introduced through one of inlets 46. For making n-type films, phosphine gas ($PH_3$) can be introduced into one of inlets 46. If it is desired to increase the band gap of a material, band gap increasing elements such as carbon or nitrogen can be incorporated into the films by introducing methane ($CH_4$) or ammonia ($NH_3$) into one of inlets 46 during deposition. The reaction gases can be sequentially introduced to result in the formation of any desired device configuration.

Various applications of the improved amorphous alloys produced by the unique processes of the invention are illustrated in Figures 2 through 7. Figure 2 shows a Schottky barrier solar cell 142 in fragmentary cross section. The solar cell 142 includes a substrate or electrode 144 of a material having good electrical conductivity properties making an ohmic contact with an amorphous alloy 146 compensated or altered to provide a reduced density of localized states in the energy gap, preferably not exceeding $10^{16}$ per cubic centimeter per electron-volt. Substrate 144 may comprise a low work function metal, such as aluminum, tantalum, stainless steel or other material matching with the amorphous alloy 146 which preferably includes silicon. It is most preferred that the alloy have a region 148 next to electrode 144, that forms an $n^+$-type conductivity, heavily doped, low-resistance interface between the electrode and an updoped, relatively high dark resistance region 150 that is a nearly intrinsic type, low conductivity n-type region.

A surface of amorphous alloy 146 joins a metallic region 152. The interface between metallic region 152 and amorphous alloy 146 forms a Schottky barrier 154. Metallic region 152 is transparent or semi-transparent to solar radiation, has good electrical conductivity and is of a high work function (for example, 4.5 eV or greater, produced, for example, by gold, platinum, palladium, etc.) relative to that of amorphous alloy 146. Metallic region 152 may be a single layer of a metal or it may include several layers. Amorphous alloy 146 may have a thickness of about .5 to 1 micrometers and metallic region 152 may have a thickness of about 10 nanometers in order to be semi-transparent to solar radiation.

A grid electrode 156 made of a metal having good electrical conductivity is deposited on metallic region 152. The grid may comprise orthogonally related lines on conductive material occupying only a minor portion of the area of the metallic region, the rest of which is to be exposed to solar energy. For example, grid 156 may occupy only about from 5 to 10 percent of the entire area of metallic region 152. Grid electrode 156 uniformly collects current from metallic region 152 to assure a good, low series resistance for the device.

An anti-reflection layer 158 may be applied over grid electrode 156 and the areas of metallic region 152 between the grid electrode areas. Anti-reflection layer 158 has a solar radiation incident surface 160. Anti-reflection layer 158 may have a thickness on the order to magnitude of the wavelength of the maximum energy point of the solar radiation spectrum, divided by four times the index of refraction of anti-reflection layer 158. If metallic region 152 is platinum of 10 nanometer thickness, a suitable anti-reflection layer 158 would be zirconium oxide of about 50 nanometer in thickness with an index of refraction of 2.1.

Schottky barrier 154 formed at the interface between the regions 150 and 152 enables photons from solar radiation to generate electron-hole pairs in alloy 146 that are collected as current by grid electrode 156. An oxide layer (not shown) can be added between layers 150 and 152 to produce an MIS (metal insulator semiconductor) solar cell.

A solar cell 162 in Figure 3 generally includes a transparent electrode 164 through which the solar radiation energy penetrates into the body of the solar cell involved. Between this transparent electrode and an opposite electrode 166 is a deposited amorphous alloy 168, preferably including silicon, initially compensated in the manner previously described. In this amorphous alloy 168 are at least two adjacent regions 170 and 172 where the amorphous alloy has respectively oppositely doped regions, region 170 being shown as an n-type conductivity region and region 172 being shown as p-type conductivity region. The doping of regions 170 and 172 is only sufficient to move the Fermi levels to the valence and conduction bands involved so that the dark conductivity remains at a low value achieved by the band adjusting and compensating or altering method of the invention. Alloy 168 has high conductivity, highly doped ohmic contact interface regions 174 and 176 of the same conductivity type as the adjacent region of alloy 168. Alloy regions 174 and 176 contact electrodes 164 and 166 respectively.

An amorphous alloy 180 has been deposited in accordance with the invention, has no p-n junctions as in the embodiment shown in Figure 4 and is located between a transparent electrode 182 and a substrate electrode 184. In a photodetector device it is desirable to have minimum dark conductivity, so amorphous alloy 180 has an undoped, but compensated or altered region 186 and heavily doped regions 188 and 190 of the same conductivity type forming low-resistance ohmic contacts with the electrodes 182 and 184, that may form a substrate for alloy 180.

Referring to Figure 5, an electrostatic image-producing device 192 (such as a xerography drum) is illustrated. The device 192 has a low dark conductivity, selective wavelength threshold, undoped or slightly p-type amorphous, oxygen stabilized alloy 194, deposited on a suitable substrate 196 such as a drum.

Referring now to Figure 6, a p-i-n solar cell 198 is illustrated having a substrate 200 that may be glass or a flexible web formed from stainless steel or aluminum. Substrate 200 is of a width and length as desired and preferably at least 3 mils thick. An insulating layer 202 has been deposited on substrate 200 by a conventional process such as chemical deposition, vapor deposition or anodizing in the case of an aluminum substrate. Layer 202 for instance, about 5 micrometers thick, can be made of a metal oxide and can be eliminated if desired. For an aluminum substrate, layer 202 preferably is aluminum oxide ($Al_2O_3$) and for a stainless steel substrate it may be silicon dioxide ($SiO_2$) or another suitable glass.

An electrode 204 is deposited in one or more layers upon layer 202 to form a base electrode for cell 198. Substrate 200 can also form an electrode without layers 202 and 204. Electrode 204 is preferably deposited by vapor deposition. The electrode layers preferably are reflective metal electrodes of molybdenum, aluminum, chrome or stainless steel for a solar cell or a photovoltaic device. The reflective electrode is preferable since, in a solar cell non-absorbed light that passes through the semiconductor alloy is reflected from electrode 204 to again pass through the semiconductor alloy to increase the device efficiency.

The device examples shown in Figs. 6 and 7 are only illustrative of some p-i-n junction devices that can be manufactured utilizing the improved process of the invention. For example, tandem cells can also be made by the process of the present invention. Each of the devices illustrated in Figs. 6 and 7 has an alloy body having an overall thickness of between about 300 and 3,000 nanometers. This thickness ensures that there are no pinholes or other physical defects in the structure and that there is maximum light absorption efficiency. A thicker material may absorb more light, but at some thickness will not generate more current since the greater thickness allows more recombination of the light-generated electron-hole pairs. (The thicknesses of the various layers shown in Figs. 2 through 7 are not drawn to scale).

Referring first to n-i-p device 198, the device is formed by first depositing a heavily doped $n^+$-type alloy layer 206 on electrode 204. Once $n^+$-type layer 206 is deposited, an intrinsic alloy layer 208 is deposited. Intrinsic layer 208 is followed by a highly doped conductive $p^+$-type alloy layer 210 deposited as the final semiconductor layer.

Utilized as a photovoltaic device, $p^+$-type layer 210 is a low light absorption, high conductivity alloy layer. Intrinsic alloy layer 208 preferably has an adjusted wavelength threshold for a solar photoresponse, high light absorption, low dark conductivity and high photoconductivity. Layer 206 is a low light absorption, high conductivity $n^+$-type layer. The thickness of layers 206 and 210 are preferably in the range of about 5 to 50 nanometers. The thickness of amorphous, intrinsic alloy 208 is preferably between about 300 to 3,000 nanometers. Because of the shorter diffusion length of the holes, the $p^+$-type layer generally will be as thin as possible, on the order of 5 to 15 nanometers. Further, the outer layer (here $p^+$-type layer 210), whether $n^+$-type or $p^+$-type, will be kept as thin as possible to avoid absorption of light in the contact layer.

A second type of p-i-n junction device 212 is illustrated in Fig. 7. In this device a first $p^+$-type layer 214 is deposited on electrode layer 204' followed by an intrinsic amorphous alloy layer 216, an n-type amorphous alloy layer 218 and an outer $n^+$-type amorphous alloy layer 220. Further, although intrinsic alloy layer 208 or 216 (in Figs. 6 and 7) is an amorphous alloy, the other layers are not so restricted and could, for instance, be polycrystalline, such as layer 214. (The inverse of the Figs. 6 and 7 structure not illustrated, also can be utilized).

Following the deposition of the various semiconductor alloy layers in the desired order for devices 198 and 212, a TCO layer 222 (transparent conductive oxide) is added which, for example, may be indium tin oxide (ITO), cadmium stannate ($Cd_2SnO_4$), or doped tin oxide ($SnO_2$). If the alloy layers were not deposited with one or more of the desired compensating or altering elements, the TCO layer will be deposited after those elements are infused into the deposited alloy layers.

An electrode grid 224 can be added to either of devices 198 or 212 if desired. For a device having a sufficiently small area, TCO layer 222 is generally sufficiently conductive such that grid 224 is not necessary for good device efficiency.

Lastly, a transparent encapsulant 225 is deposited over grid 224. This encapsulant can comprise, for example, silicon nitride ($Si_3N_4$) or silicon dioxide ($SiO_2$) formed from the microwave deposition of silane and nitrogen or ammonia, or silane, and oxygen, respectively. These encapsulants can be called insulators or wide band gap semiconductors. Layer 225 of transparent material can have a thickness of about one to fifty micrometers.

If layer 225 is formed from silicon nitride or silicon dioxide, the deposition temperature can be room temperature to 300°C and the deposition pressure preferably can be between .13 and 5.3 pascal. The reaction gas flow range can be about 2—10 SCCM and the power density can be about .1 to 1.2 watts per cubic centimeter. For silicon nitride, the reaction gas mixture can be from .1 to 50 percent $SiH_4$ in $N_2$.

In depositing semiconductor alloy layers the reactive gas can contain band gap narrowing elements such as germanium to form an amorphous semiconductor alloy having a narrowed band gap. The microwave generator is energized and the plasma is obtained from the gas mixture. The band gap narrowing and increasing elements can be called band gap adjusting elements. Typical substrate temperatures are 275°C for amorphous silicon and germanium alloys and 200°C for amorphous germanium alloys deposited from $GeF_4$ or $GeH_4$. The doped layers of the devices are deposited at various temperatures of 250°C to 300°C depending upon the form of the material used. The upper limitation on the substrate temperature in part is due to the type of metal substrate utilized. For a hydrogen compensated amorphous alloy to be produced, such as to form the intrinsic layer in n-i-p or p-i-n devices, the substrate temperature should be less than about 400°C and preferably about 275°C.

The doping concentrations are varied to produce the desired p, $p^+$, n or $n^+$ type conductivity as the alloy layers are deposited for each device. For n or p-type doped layers, the material is doped with 5 to 100 ppm of dopant material as it is deposited. For $n^+$ or $p^+$-type doped layers the material is doped with 100 ppm to over 1 percent of dopant material as it is deposited.

Referring now to Figure 8, there is illustrated an alternative gas feed system for the apparatus of Fig. 1. The gas feed system includes a gas distribution manifold 230 within chamber 24. Manifold 230 has an extension 232 which extends through the chamber end cap (not shown) for receiving the various gas mixtures. The manifold loops around substrate 14 and includes a plurality of outlets along substantially parallel portions 234 and 236. The configuration allows the reaction gases indicated by arrows 238 to be evenly distributed over the substrates to result in a more uniform plasma. Such an arrangement is advantageous when using gases such as, for example, silicon tetrafluoride and germane, or silicon tetrafluoride and germanium tetrafluoride because the silicon compounds and germanium compounds have different disassociation energies. Without an opposed manifold, the deposited film would exhibit a compositional non-uniformity in the direction of feed gas flow across the substrate.

Apparatus for feeding atomic fluorine and/or hydrogen flows that have been separately generated is illustrated in Fig. 9. The apparatus includes a pair of conduits 240 and 242 that extend into chamber 24 on opposite sides of substrate 14. Conduits 240 and 242 are substantially equally spaced from the substrate and include outlets in the vicinity of the substrate for evenly distributing atomic fluorine and/or hydrogen (indicated by arrows 244 and 246) into the plasma over the substrate 14. The atomic fluorine and/or hydrogen can then react with the semiconductor free radicals in the plasma. The atomic fluorine and/or hydrogen and the semiconductor free radicals react to form a film on the substrate. As a result, the system of Fig. 9 provides separate control over the free radicals within the plasma to enable selective incorporation of desired species into the plasma from which the film is deposited.

Other free radicals can be introduced by adding additional conduits. Free radicals of boron can be introduced to provide substitutional doping within the deposited film to form an improved p-type alloy. Such an alloy is particularly useful in making photovoltaic devices.

Another microwave deposition system is illustrated in Fig. 10. A free radical generator 250, including a "Woods Horn" 254 known in the art, is used to feed selected free radicals 252 into chamber 254. Additional generators 250 can be provided. A microwave source as in Fig. 1 can be provided including a microwave generator 18, an antenna 19, and a reflective housing 21. Generator 18 can provide free radical generator 250 with microwave energy, or free radical generator 250 can include its own source of microwave energy.

Free radicals 252 react with the reactive species formed within the plasma from reaction gases 256 to form a film on substrate 14. Hence, as in the previous embodiment, selected free radicals can be introduced into the plasma at will to form new and improved amorphous semiconductor alloys.

A modified Paschen curve 260 for conventional radio frequency deposition of $SiH_4$ is illustrated in Fig. 11. The normal operating range is dictated by the minimum of the curve, which for the curve shown is about 27 to 33 pascal.

A modified Paschen curve 262 for the microwave deposition process of the invention, using $SiH_4$ as the reaction gas, is plotted in Fig. 12. In comparison to curve 260, curves 262 shows a shift to lower pressure for the microwave deposition process of the invention, that results in an operating range of about 10 to 13 pascal or below for the invention.

Amorphous semiconductor alloy films can be deposited by the method of the present invention in the following ranges of operating parameters.

Pressure: .13 to 13 pascal

Deposition Rate: 5 to 25 nanometers per second

Substrate Temperature: 250°C to 325°C

Power Density: .1 watts/$cm^3$ to 1.2 watts/$cm^3$

Reaction Gas Conversion Efficiency: Essentially or substantially 100 percent.

Examples of some specific films deposited by the process of the invention are:

an amorphous Si:H alloy film deposited from $SiH_4$ at 12 nanometers per second, at 6.6 pascal at 300°C;

an amorphous Si:H:F alloy film deposited from a mixture of 2 parts $SiF_4$ to 9 parts $SiH_4$ at 12.5 nanometers per second, at 8.6 pascal at 300°C:

an $Si_3N_4$ alloy film deposited from equal parts of $SiH_4$ and $N_2$ at 13.3 nanometers per second at 5.3 pascal at 300°C;

an $SiO_2$ alloy film deposited from five parts of an equal mixture of $O_2$ in $SiF_4$ and 1 part $H_2$ at 5.5 nanometers per second, at 5.3 pascal, at 300°C. The amorphous Si:H and Si:H:F alloy films made by the present invention have activation energies of 0.7 to 0.8 eV, photoconductivities under one sun (AM1) illumination of about $3\times10^{-5}$ or better and dark photoconductivities of about $5\times10^{-10}$ or better which indicates alloys of good electronic quality. To further emphasize the effects of the pressure difference, two alloy films were deposited in the same system with only the pressure being changed. The alloy films were both deposited at about the same rate of 15 nanometers per second from a mixture of 30 parts $SiH_4$ to 7.2 parts of $SiF_4$ at 300°C. The first alloy film was deposited at 3 pascal and had a photoconductivity under one sun illumination of $4\times10^{-6}$ and a dark photoconductivity of $4\times10^{-11}$. The second alloy film was deposited at 16 pascal and had a photoconductivity under one sun illumination of $5\times10^{-7}$ and a dark photoconductivity of $1.3\times10^{-9}$, caused by the increase in defect density.

These films are amorphous in structure. The term "amorphous" means an alloy or material that has long-range disorder, although it may have short or intermediate order or even contain at times some crystalline inclusions.

**Claims**

1. A process for depositing an amorphous semiconductor alloy film onto a substrate from a glow discharge excited by microwave energy, the process comprising coupling microwave energy having a frequency of 2.45 Ghz into a substantially enclosed reaction vessel (12) containing a substrate (14), and introducing into the vessel reaction gas to establish a glow discharge plasma within the vessel containing reaction gas species derived from the reaction gas, characterised in that the reaction vessel is maintained at a pressure corresponding substantially to that represented by the minimum on the Paschen curve.

2. A process according to claim 1, characterised in that the alloy film is deposited at a rate greater than 5 nanometers per second.

3. A process according to claim 1, characterised in that the reaction gas includes silicon.

4. A process according to claim 3, characterised in that the reaction gas includes nitrogen.

5. A process according to claim 3, characterised in that the reaction gas includes oxygen.

6. A process according to claim 1, characterised in that the reaction gas includes germanium.

7. A process according to any one of the preceding claims, characterised in that the reaction gas includes a dopant-containing compound.

8. A process according to any one of the preceding claims, characterised by introducing a plasma sustaining gas into the vessel with the reaction gas.

9. A process according to any one of the preceding claims, wherein the deposited semiconductor film (22) has a band gap, and the reaction gas includes a band gap adjusting element.

10. A process according to claim 9, characterised in that the reaction gas includes one of carbon, nitrogen and germanium as a band gap adjusting element.

11. A process according to any one of the preceding claims, characterised in that the microwave energy has a power density between 0.1 and 1.2 watts per cubic centimeter.

**Patentansprüche**

1. Verfahren zum Niederschlagen eines Films von amorphen halbleitenden Legierungen auf einem Substrat aus einer mittels Mikrowellenenergie angeregten Glühentladung wobei das Verfahren die Schritte umfaßt, bei denen Mikrowellenenergie (1) mit einer Frequenz von 2,45 GHz in einen im wesentlichen geschlossenen Reaktionsbehälter (12), der ein Substrat (14) enthält, zu übertragen und in den Behälter Reaktionsgas einzubringen, um ein Glühentladungsplasma innerhalb des Behälters zu schaffen, der von dem Reaktionsgas abgezweigte Proben des Reaktionsgases enthält, dadurch gekennzeichnet, daß das Reaktionsgefäß auf einen Druck eingestellt wird, der im wesentlichen demjenigen entspricht, der durch das Minimum der Paschen-Kurve dargestellt wird.

2. Verfahren gemäß Anspruch 1, dadurch gekennzeichnet, daß der Legierungsfilm mit einer Geschwindigkeit größer als 5 Nanometer/Sekunde niedergeschlagen wird.

3. Verfahren gemäß Anspruch 1, dadurch gekennzeichnet, daß das Reaktionsgas Silicium umfaßt.

4. Verfahren gemäß Anspruch 3, dadurch gekennzeichnet, daß das Reaktionsgas Stickstoff umfaßt.

5. Verfahren gemäß Anspruch 3, dadurch gekennzeichnet, daß das Reaktionsgas Sauerstoff umfaßt.

6. Verfahren gemäß Anspruch 1, dadurch gekennzeichnet, daß das Reaktionsgas Germanium umfaßt.

7. Verfahren gemäß einem der vorstehenden Ansprüche, dadurch gekennzeichnet, daß das Reaktionsgas eine ein Dotierungsmittel enthaltende Verbindung umfaßt.

8. Verfahren gemäß einem der vorstehenden Ansprüche, dadurch gekennzeichnet, daß ein Plasma aufrechterhaltendes Gas in den Behälter mit dem Reationsgas eingeführt wird.

9. Verfahren gemäß einem der vorstehenden Ansprüche, wobei die niedergeschlagene halbleitende Film (22) einen Bandabstand aufweist und das Reaktionsgas ein solches Element enthält, das einen Bandabstand ausrichtet.

10. Verfahren gemäß Anspruch 9, dadurch gekennzeichnet, daß das Reaktionsgas eines der Element Kohlenstoff, Stickstoff und Germanium als das Element umfaßt, das einen Bandabstand ausrichtet.

11. Verfahren gemäß einem der vorstehenden Ansprüche, dadurch gekennzeichnet, daß die Mirkowellenenergie eine Energiedichte zwischen 0,1 bis 1,2 Watt pro Kubikzentimeter hat.

**Revendications**

1. Procédé pour déposer un film d'alliage semiconducteur amorphe sur un substrat à partir d'une décharge incandescente excitée par une énergie micro-onde, le procédé comportant le fait de coupler l'énergie micro-onde, d'une fréquence de 2.45 GHz, dans un récipient à réaction (12) substantiellement clos et contenant un substrat (14), et d'introduire dans le récipient un gaz de réaction pour établir un plasma, résultant de la décharge incandescente, dans le récipient contenant les produits dérivés du gaz de réaction, caractérisé en ce que l'on maintient le récipient en réaction sous une pression correspondant sensiblement à celle représentée par le minimum de la courbe de Paschen.

2. Procédé selon la revendication 1, caractérisé en ce que l'on dépose le film d'alliage à une vitesse supérieure à 5 nanomètres par seconde.

3. Procédé selon la revendication 1, caractérisé en ce que le gaz de réaction comprend du silicium.

4. Procédé selon la revendication 3, caractérisé en ce que le gaz de réaction comprend de l'azote.

5. Procédé selon la revendication 3, caractérisé en ce que le gaz de réaction comprend de l'oxygène.

6. Procédé selon la revendication 1, caractérisé en ce que le gaz de réaction comprend du germanium.

7. Procédé selon l'une quelconque des revendications précédentes, caractérisé en ce que le gaz de réaction comprend un composé contenant un dopant.

8. Procédé selon l'une quelconque des revendications précédentes, caractérisé par le fait que l'on introduit dans le récipient, avec le gaz de réaction, un gaz favorisant le plasma.

9. Procédé selon l'une quelconque des revendications précédentes, dans lequel le film semiconducteur déposé (22) présente un saut de bande et dans lequel le gaz de réaction contient un élément d'adjustement du saut de bande.

10. Procédé selon la revendication 9, caractérisé en ce que le gaz de réaction contient comme élément d'adjustment du saut de bande soit du carbone, de l'azote ou du germanium.

11. Procédé selon l'une quelconque des revendications précédentes, caractérisé en ce que l'énergie micro-onde a une densité de puissance comprise entre 0.1 et 1.2 watts par centimètre cube.

FIG. 1

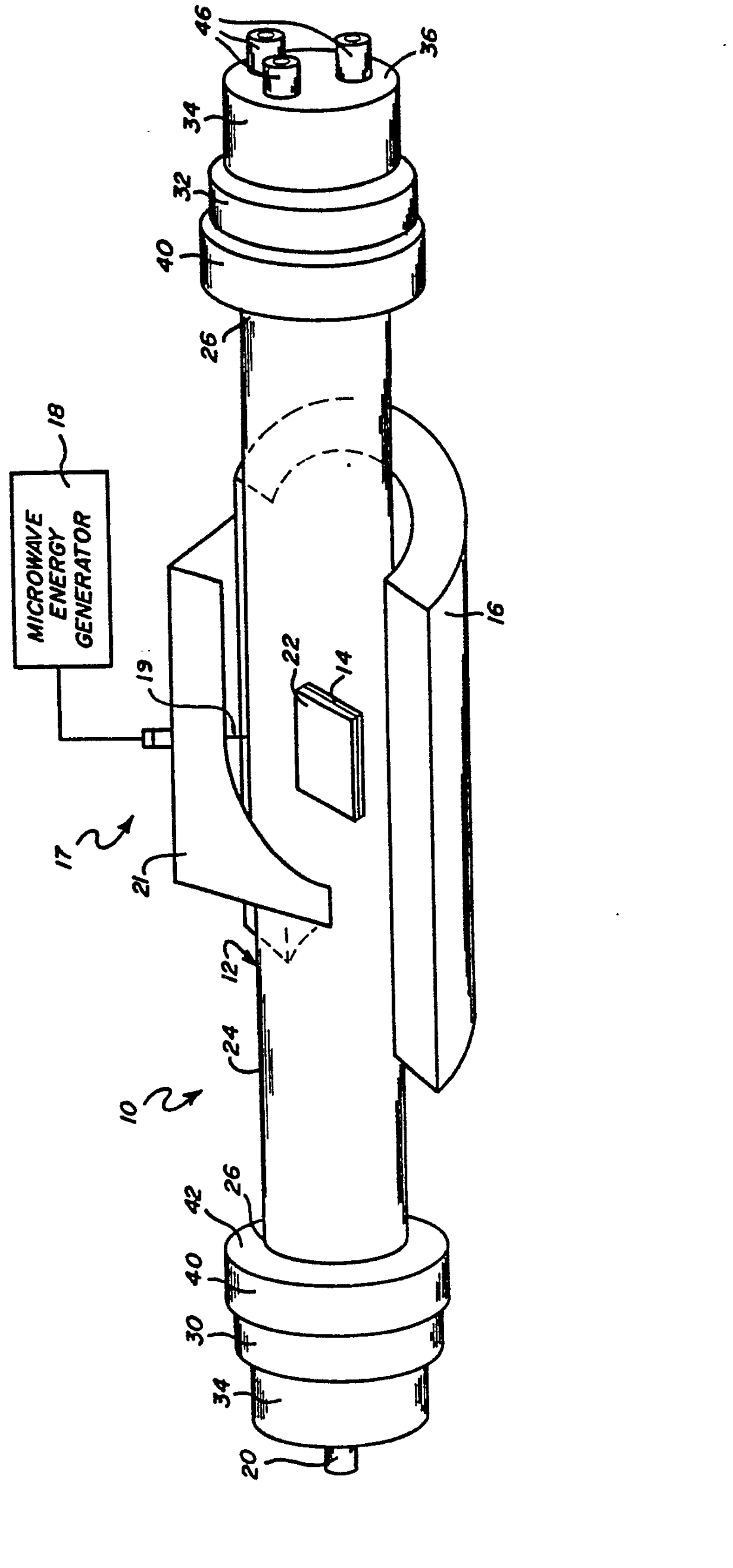
MICROWAVE
ENERGY
GENERATOR
18
46
36
34
32
40
26
16
22
14
19
17
21
12
24
10
42
30
20

FIG 2

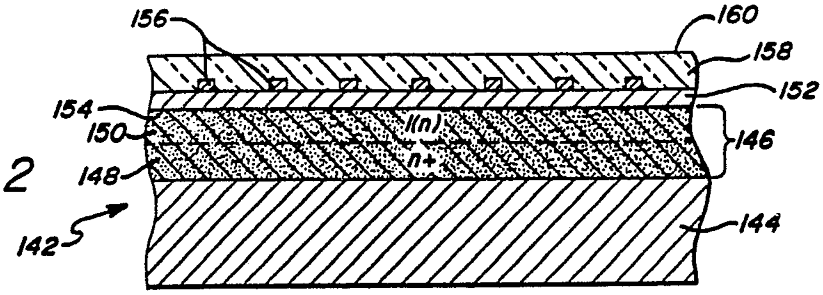


FIG 3

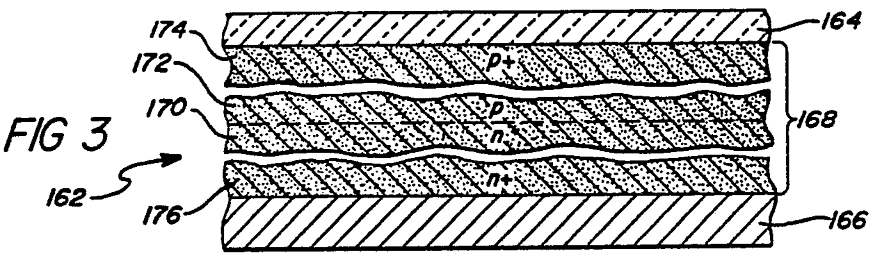


FIG 4

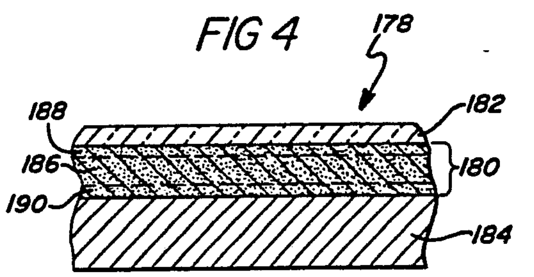


FIG 5

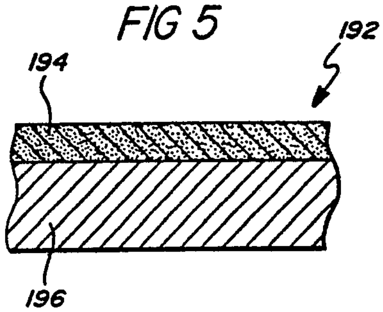


FIG 6

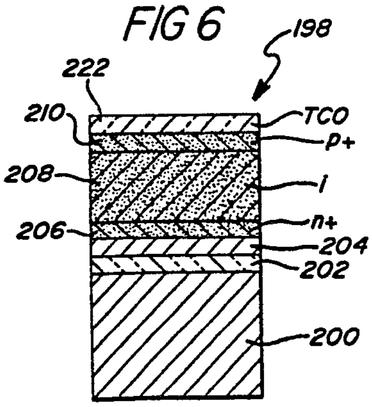


FIG 7

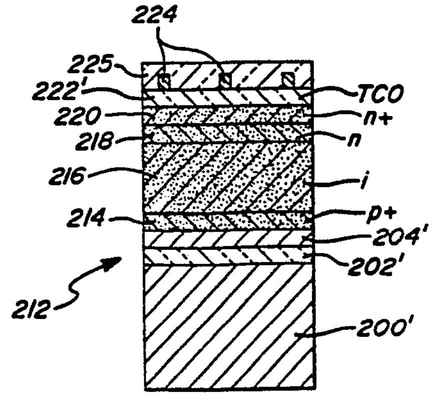

FIG.8

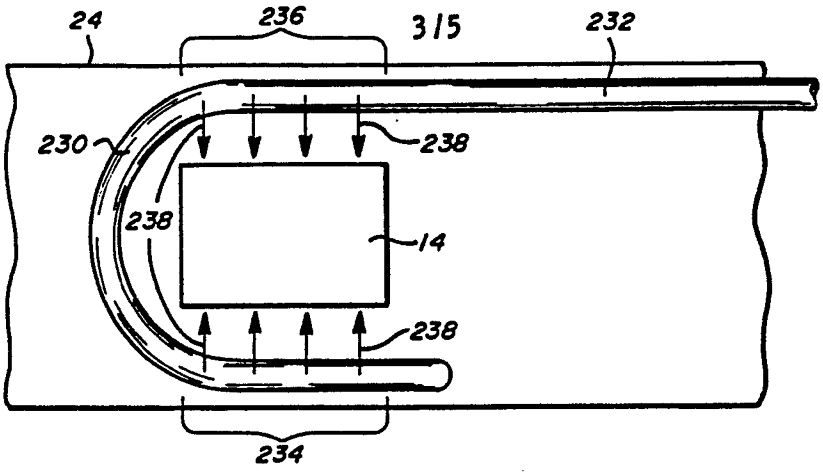


FIG. 9

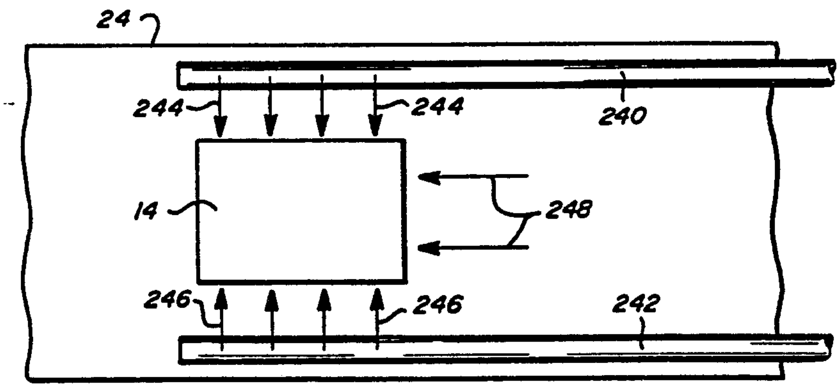


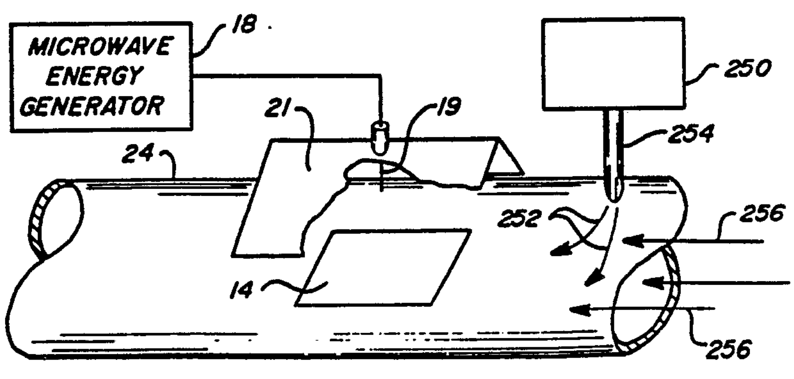


FIG. 10

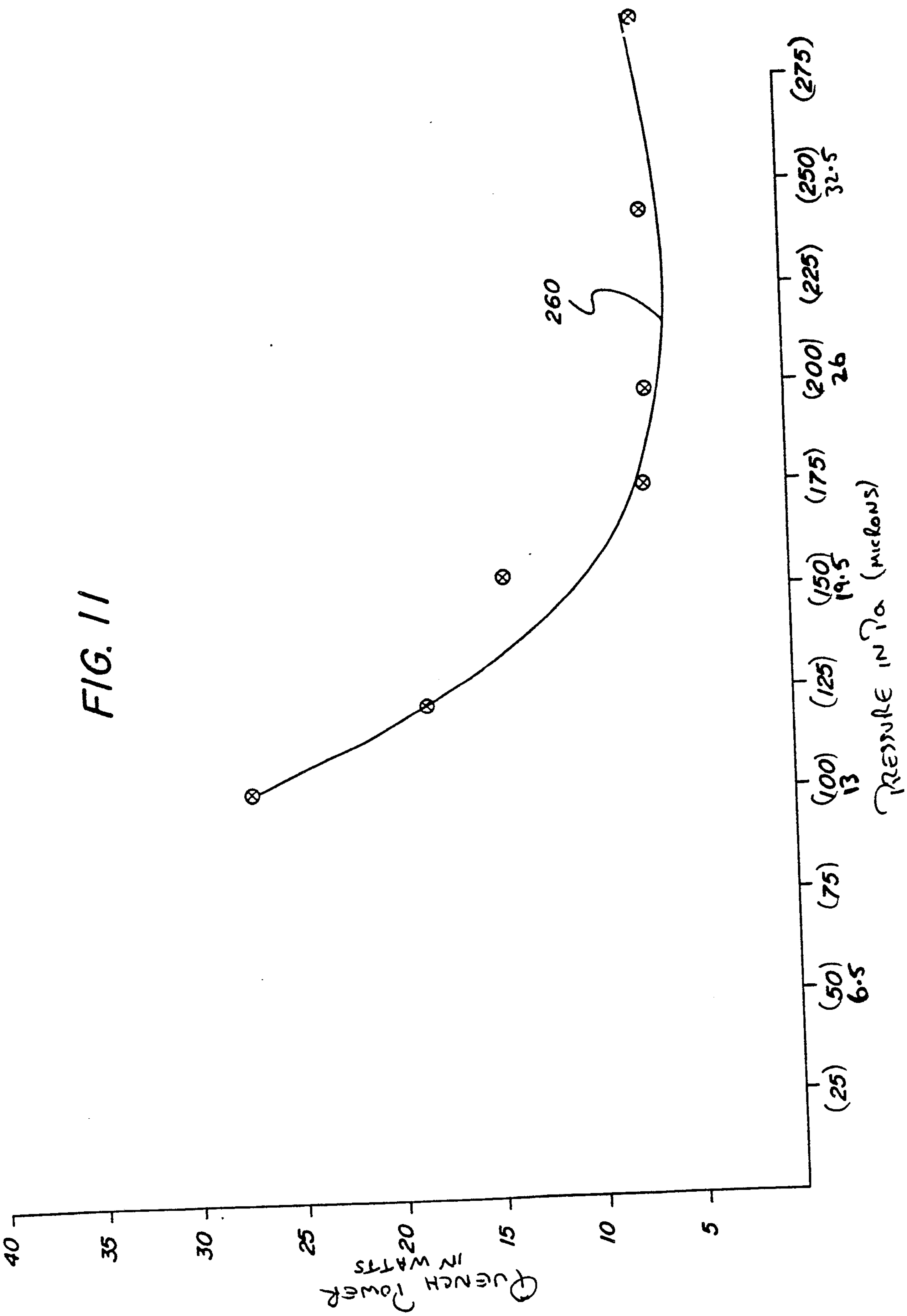
260
(25)
(50) 6.5
(75)
(100) 13
(125)
(150) 19.5
(175)
(200) 26
(225)
(250) 32.5
(275)
PRESSURE IN Pa (MICRONS)
5
10
15
20
25
30
35
40
QUENCH POWER IN WATTS

FIG. 11

FIG 12

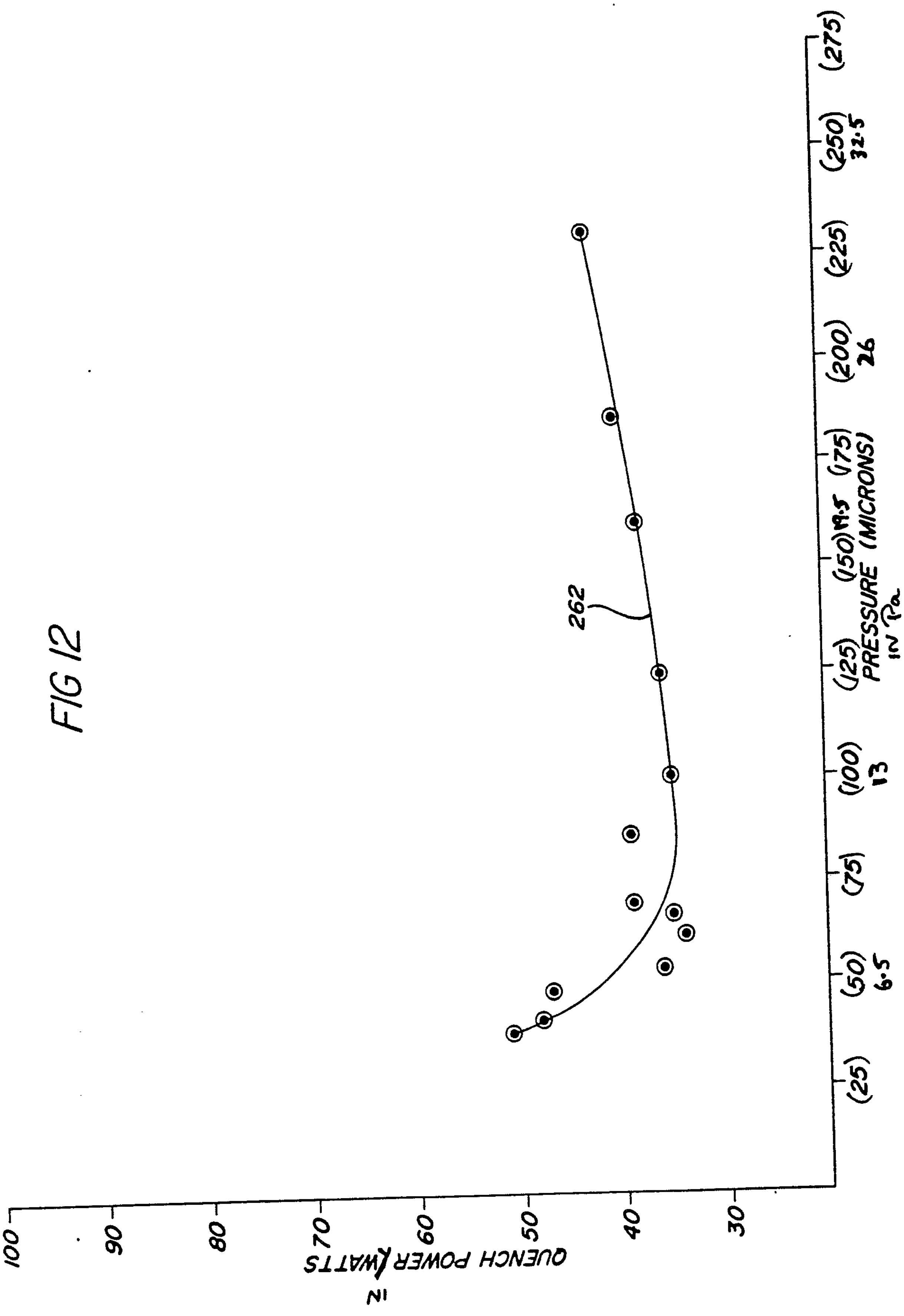
262
(25)
(50) 6.5
(75)
(100) 13
(125)
(150) 19.5
(175)
(200) 26
(225)
(250) 32.5
(275)
PRESSURE (MICRONS)
IN Pa
100
90
80
70
60
50
40
30
QUENCH POWER (WATTS
IN